# EUROPEAN PATENT APPLICATION

(11) **EP 4 675 145 A1**
(43) Date of publication of application: **07.01.2026**
(21) Application number: 24763177.3
(22) Date of filing: 28.02.2024
(51) Int. Cl.: F16L 29/00, H01L 21/67

(54) **ADAPTER APPARATUS AND SEMICONDUCTOR PROCESS DEVICE**

(30) Priority: 28.02.2023 CN 202310214428
(71) Applicant: Beijing NAURA Microelectronics Equipment Co., Ltd., Beijing 100176 (CN)
(72) Inventor: LIU, Dongxu, Beijing 100176 (CN); MA, Hongshuai, Beijing 100176 (CN); NAN, Jianhui, Beijing 100176 (CN); ZHAO, Hongyu, Beijing 100176 (CN)
(74) Representative: Cohausz & Florack
(86) International application number: PCT/CN2024/078927
(87) International publication number: WO 2024/179497

(57) **Abstract**

There are provided an adapter apparatus and a semiconductor process device using the same. The adapter apparatus (300) is configured to connect a water resistance meter (200) to a process tank (100), and includes a housing part (310) and a blocking part (320), the housing part is provided with a first inner cavity (313), and the first inner cavity is configured to be respectively connected with the process tank and the water resistance meter; the blocking part is movably disposed in the first inner cavity to be switched between a first position and a second position; in a case where the blocking part is at the first position, the blocking part blocks the first inner cavity; and in a case where the blocking part is at the second position, the process tank is connected with the water resistance meter through the first inner cavity. The adapter apparatus can avoid damage to the water resistance meter, and obviates the need for an operator to detach and mount the water resistance meter, thereby overcoming the problems of complex operation and low equipment productivity.

## Description

### TECHNICAL FIELD

The present disclosure relates to, but is not limited to, the technical field of semiconductor process devices, and particularly relates to an adapter apparatus and a semiconductor process device.

### BACKGROUND

A tank-type cleaning machine is a common semiconductor processing device used for cleaning wafers. Certainly, in order to further develop the potential of the device, the tank-type cleaning machine in the related art not only has a cleaning function, but also has other functions (such as being filled with a chemical solution for reaction or performing a wet etching process on a wafer). In a specific application, a process tank of the tank-type cleaning machine may be used to clean a wafer when being filled with deionized water. The residual chemical solution or particles of a previous process are rinsed from the wafer by the continuous overflow of the deionized water. A water resistance meter is needed for checking whether the wafer is clean. The water resistance meter is configured to measure a resistance value of the overflowing water. When the resistance value of the overflowing water is greater than or equal to 18 MΩ (i.e., a resistance value of the deionized water), it is indicated that the wafer is clean enough for a next process. When the process tank is filled with a chemical solution for other processes, the chemical solution in the process tank is required not to overflow to the water resistance meter, otherwise the water resistance meter is damaged.

In the related art, in order to avoid the damage to the water resistance meter by the chemical solution, the water resistance meter is detached manually. Certainly, when the water resistance meter is needed for detection, an operator remounts the water resistance meter on the process tank. Although the damage to the water resistance meter can be avoided with the above method, there is a problem that the detachment and mounting operations are complex, which is not favorable for highly efficient use of the semiconductor process device.

### SUMMARY

The present disclosure provides an adapter apparatus and a semiconductor process device, so as to at least solve the problem in the related art that the need for the operator to manually detach and mount the water resistance meter causes complex operation, which is not favorable for highly efficient use of the semiconductor process device.

In order to at least solve the above technical problem, the present disclosure is implemented in a following way.

In a first aspect, the present disclosure provides an adapter apparatus, which is configured to connect a water resistance meter to a process tank, and includes a housing part and a blocking part;
the housing part is provided with a first inner cavity, and the first inner cavity is configured to be respectively connected with the process tank and the water resistance meter; and
the blocking part is movably disposed in the first inner cavity to be switched between a first position and a second position; in a case where the blocking part is at the first position, the blocking part blocks the first inner cavity; and in a case where the blocking part is at the second position, the process tank is connected with the water resistance meter through the first inner cavity.

In a second aspect, the present disclosure provides a semiconductor process device, including a process tank, a water resistance meter, and the above adapter apparatus, wherein
the process tank is provided with an overflow hole;
the adapter apparatus is disposed outside the process tank, and the first inner cavity is connected with the overflow hole; and
the water resistance meter is mounted on the housing part, and is connected with the first inner cavity.

In a third aspect, the present disclosure provides another semiconductor process device, including a process tank, a water resistance meter, and an adapter apparatus, wherein
the process tank is provided with an overflow hole, and the adapter apparatus is mounted outside the process tank, and is connected with the process tank through the overflow hole;
the water resistance meter is mounted on the adapter apparatus, and the adapter apparatus has a first state and a second state;
in a case where the semiconductor process device is in a cleaning state, the adapter apparatus is in the second state, and connects the water resistance meter with the process tank; and
in a case where the semiconductor process device is in a non-cleaning state, the adapter apparatus is in the first state, and isolates the water resistance meter from the process tank.

The technical solutions adopted in the present disclosure can produce the following technical effects:
compared with the method described in the background part that the water resistance meter is frequently detached and mounted to be prevented from being damaged by the chemical solution, in the semiconductor process device provided in the embodiments of the present disclosure, the detachment and mounting operations performed on the water resistance meter for preventing the damage by the chemical solution are not needed once the water resistance meter is connected to the process tank through the adapter apparatus, and only the state of the adapter apparatus needs to be adjusted. Apparently, compared with a large workload and a long time for frequently detaching and mounting the water resistance meter, the semiconductor process device provided in the embodiments of the present disclosure achieves the same purpose by adjusting the adapter apparatus, with no need for a large workload or a long time, so that an operation load is reduced, and an improvement in productivity of the semiconductor process device is also facilitated.

### BRIEF DESCRIPTION OF DRAWINGS

FIG. 1 is a schematic structural diagram of a semiconductor process device according to an embodiment of the present disclosure;
FIG. 2 and FIG. 3 are schematic structural diagrams of different parts of a semiconductor process device according to an embodiment of the present disclosure;
FIG. 4 and FIG. 5 are partial cross-sectional views of part of a structure of a semiconductor process device according to an embodiment of the present disclosure in different states; and
FIG. 6 is an exploded view of part of a structure of a semiconductor process device according to an embodiment of the present disclosure.

### Description of reference numerals:

100-process groove, 101-overflow hole,
200-water resistance meter,
300-adapter apparatus, 310-housing part, 301-first sub-housing, 302-second sub-housing, 303-first positioning groove, 304-first seal ring, 305-second positioning groove, 306-second seal ring, 307-third seal ring, 308-fourth seal ring, 309-fifth seal ring, 311-water inlet, 312-water outlet, 313-first inner cavity, 314-second inner cavity, 315-first fluid pass-through hole, 316-second fluid pass-through hole, 317-first sub-cavity, 318-second sub-cavity, 319-tapered hole,
320-blocking part, 330-rod part, 340-isolation sleeve, 350-piston,
410-first adapter, 420-second adapter,
510-branch, 520-switching valve, 530-common pipe,
610-first threaded connector, 620-second threaded connector.

### DETAIL DESCRIPTION OF EMBODIMENTS

In order to make the objectives, technical solutions and advantages of the present disclosure clearer, the technical solutions of the present disclosure are clearly and thoroughly described below in conjunction with the specific embodiments and the drawings of the present disclosure. Apparently, the embodiments described herein are just some embodiments of the present disclosure, and do not cover all embodiments. All other embodiments derived by those of ordinary skill in the art from the embodiments described herein without any inventive work fall within the scope of the present disclosure.

The technical solutions provided in the embodiments of the present disclosure are described in detail below with reference to the drawings.

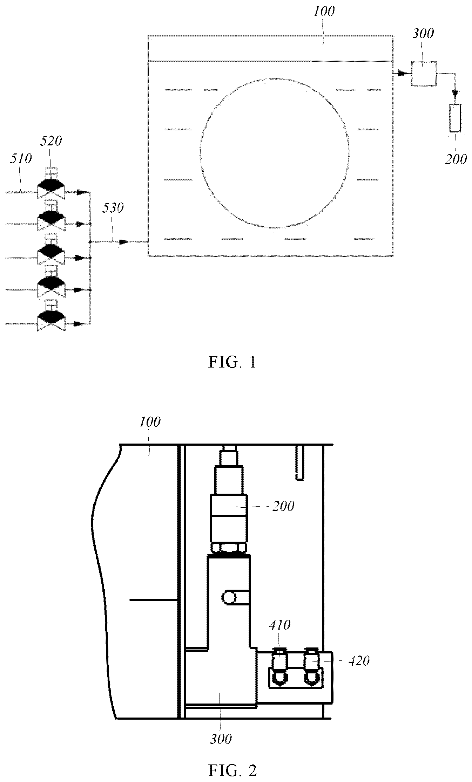

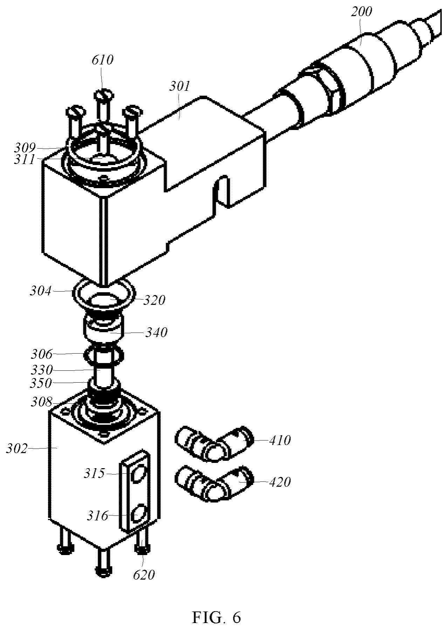

Referring to FIG. 1 to FIG. 6, the embodiments of the present disclosure provide a semiconductor process device, including a process tank 100, a water resistance meter 200, and an adapter apparatus 300.

The process tank 100 is a component of the semiconductor process device provided in the embodiments of the present disclosure. The process tank 100 is configured to contain a process liquid. The process liquid is used in a corresponding process performed on a semiconductor substrate (e.g., a wafer) placed in the process tank 100.

Certainly, different kinds of processes are performed on the semiconductor substrate by the semiconductor process device based on different types of process liquids. For example, when the process liquid is a chemical solution (e.g., an HF solution, an H₂O₂ solution, an NH₄OH solution, or an HCl solution.), the process performed by the semiconductor process device on the semiconductor substrate is a reaction process, in which case the semiconductor process device is in a non-cleaning state. For example, when the process liquid is water (e.g., deionized water or ultra-pure water), the process performed by the semiconductor process device on the semiconductor substrate is a water-wash process, in which case the semiconductor process device is in a cleaning state. It should be noted that the process liquid for cleaning the semiconductor substrate is not limited to water, and may be other cleaning liquids, and the term "water" used herein refers to all the process liquids capable of cleaning the semiconductor substrate.

The water resistance meter 200 is a device for detecting a resistance value of water. The water resistance meter 200 may be a water resistance detection device which meets detection accuracy requirements of the semiconductor process device. A specific type of the water resistance meter 200 is not limited in the embodiments of the present disclosure.

In a case where the semiconductor process device is in the cleaning state, the process liquid contained in the process tank 100 is water, and the water resistance meter 200 needs to detect an actual resistance value of the water overflowing from the process tank 100 during the cleaning process, and the semiconductor process device may determine whether the semiconductor substrate is clean based on the actual resistance value of the overflowing water. The process tank 100 may be provided with an overflow hole 101, and in the cleaning state, the water entering the process tank 100 may flow out through the overflow hole 101 after rinsing the semiconductor substrate.

Certainly, a specific determination method may be the method described in the background part, that is, when the actual resistance value is greater than or equal to a preset resistance value (e.g. 18 MΩ, which is the resistance value of deionized water), it is indicated that cleanliness of the overflowing water reaches a preset requirement, and it is also reflected that no residues are rinsed away from the semiconductor substrate, so that it may be determined that the semiconductor substrate is clean. It should be noted that different preset resistance values are adopted for different cleaning liquids, and a specific value of the preset resistance value is not limited in the embodiments of the present disclosure.

In a case where the semiconductor process device is in the non-cleaning state, the semiconductor process device does not need the water resistance meter 200 to work. Further, the water resistance meter 200 may be damaged once the chemical solution in the process tank 100 flows into the water resistance meter 200. That is, the chemical solution in the process tank 100 needs to be prohibited from entering the water resistance meter 200 when the semiconductor process device is in the non-cleaning state.

In the embodiments of the present disclosure, the adapter apparatus 300 is a component of the semiconductor process device provided in the embodiments of the present disclosure, and can perform an adapting function. Specifically, the adapter apparatus 300 is configured to connect the water resistance meter 200 to the process tank 100. In other words, the water resistance meter 200 is indirectly connected to the process tank 100 through the adapter apparatus 300, so as to be mounted. The water resistance meter 200 is mounted on the process tank 100 through the adapter apparatus 300 no matter the semiconductor process device is in the cleaning state or the non-cleaning state.

The adapter apparatus 300 is connected outside the process tank 100, and may selectively connect the water resistance meter 200 to the process tank 100 or disconnect the water resistance meter 200 from the process tank 100, so that the water resistance meter 200 may detect the resistance value of water when the semiconductor process device is in the cleaning state and may be prevented from being damaged by the chemical solution when the semiconductor process device is in the non-cleaning state.

Specifically, the adapter apparatus 300 provided in the embodiments of the present disclosure may be in a first state and a second state, so as to adapt to the non-cleaning state and the cleaning state of the semiconductor process device, respectively.

In a case where the semiconductor process device is in the cleaning state, the adapter apparatus 300 is in the second state, and the adapter apparatus 300 in the second state may connect the water resistance meter 200 with the process tank 100, so as to enable the water overflowing from the process tank 100 to flow into the water resistance meter 200 through the adapter apparatus 300 and then be detected by the water resistance meter 200 in the cleaning process. Specifically, the adapter apparatus 300 may be connected with the process tank 100 through the overflow hole 101.

In a case where the semiconductor process device is in the non-cleaning state, the adapter apparatus 300 is in the first state, and the adapter apparatus 300 in the first state may isolate the water resistance meter 200 from the process tank 100. In other words, the chemical solution overflowing from the process tank 100 cannot flow into the water resistance meter 200 through the adapter apparatus 300, so as not to damage the water resistance meter 200.

It should be noted that the state of the adapter apparatus 300 may be adjusted only by moving at least part of the components of the adapter apparatus 300 by an operator.

The semiconductor process device provided in the embodiments of the present disclosure is provided with the adapter apparatus 300, so that the water resistance meter 200 can be mounted on the process tank 100 through the adapter apparatus 300, and meanwhile, the adapter apparatus 300 can selectively change the state thereof to achieve the connection between the water resistance meter 200 and the process tank 100 in the second state and the isolation between the water resistance meter 200 and the process tank 100 in the first state. The semiconductor process device with such structure can ensure that the water resistance meter 200 detects resistance of the water overflowing from the process tank 100 in the cleaning state and prevents the chemical solution in the process tank 100 from overflowing into the water resistance meter 200 through the adapter apparatus 300 in the non-cleaning state, thereby avoiding the damage to the water resistance meter 200.

Compared with the method described in the background part that the water resistance meter 200 is frequently detached and mounted to be prevented from being damaged by the chemical solution, in the semiconductor process device provided in the embodiments of the present disclosure, the detachment and mounting operations performed on the water resistance meter 200 for preventing the damage by the chemical solution are not needed once the water resistance meter 200 is mounted to the process tank 100 through the adapter apparatus 300, and only the state of the adapter apparatus 300 needs to be adjusted. Apparently, compared with a large workload and a long time for frequently detaching and mounting the water resistance meter 200, the semiconductor process device provided in the embodiments of the present disclosure achieves the same purpose by adjusting the adapter apparatus 300, with no need for a large workload or a long time, so that an operation load is reduced, and an improvement in productivity of the semiconductor process device is also facilitated.

Various structures can be adopted for performing the functions of the adapter apparatus 300 provided in the embodiments of the present disclosure, and a specific structure of the adapter apparatus 300 is not limited in the embodiments of the present disclosure.

In some embodiments, the adapter apparatus 300 may be provided with a communication hole, a first port of the communication hole is located at a first end of the adapter apparatus 300, a second port of the communication hole is located at a second end of the adapter apparatus 300, the first end of the adapter apparatus 300 is rotatably connected outside the process tank 100, the first port of the communication hole may be connected with or disconnected from the process tank 100, and the second port of the communication hole is connected with the water resistance meter 200.

In a specific operation process, the operator may rotate the adapter apparatus 300 relative to the process tank 100 by rotating the adapter apparatus 300, so as to rotate the first port to be in a state in which the first port is connected with the overflow hole 101 of the process tank 100, thereby switching the adapter apparatus 300 to the second state. In this case, the communication hole connects the overflow hole 101 with the water resistance meter 200, so that the adapter apparatus 300 connects the process tank 100 with the water resistance meter 200.

The operator may continue to rotate the adapter apparatus 300 to enable the adapter apparatus 300 to further rotate relative to the process tank 100, so as to rotate the first port to be in a state in which the first port is not connected with the overflow hole 101 of the process tank 100. In this case, it may be regarded that an outer wall of the process tank 100 covers the first port and the adapter apparatus 300 covers the overflow hole 101, so that the adapter apparatus 300 is switched to the first state. Since the first port is not connected with the overflow hole 101 of the process tank 100 (i.e., blocking), the chemical solution in the process tank 100 cannot enter the adapter apparatus 300, let alone entering the water resistance meter 200 through the adapter apparatus 300. In other words, with the first port not connected with the overflow hole 101 of the process tank 100, the isolation of the water resistance meter 200 from the process tank 100 by the adapter apparatus 300 is actually achieved

As can be seen from the above operation process, the entire adapter apparatus 300 is rotatably connected to the process tank 100, the method of adjusting the state of the adapter apparatus 300 by rotating the entire adapter apparatus 300 has the advantage of simple operation, and the adapter apparatus 300 only needs to be provided with one communication hole, without more components and complex structure, which facilitates simplification of the structure of the adapter apparatus 300.

As described above, the adapter apparatus 300 provided in the embodiments of the present disclosure may adopt various structures. Other embodiments of the present disclosure provide a specific adapter apparatus 300, which may include a housing part 310 and a blocking part 320.

The housing part 310 is a housing of the adapter apparatus 300. The housing part 310 is configured to form some structures (such as a water inlet 311 and a water outlet 312, which will be described below) of the adapter apparatus 300, and is further configured to provide mounting positions for other components (such as the blocking part 320) of the adapter apparatus 300, and cooperate with those components for performing corresponding functions.

Moreover, the housing part 310 may also serve as a member for connecting the adapter apparatus 300 to the process tank 100. In an alternative embodiment, the housing part 310 may be fixedly connected to the outer wall of the process tank 100 by welding, bonding, or a connector (e.g., a first threaded connector 610), and a specific connection method for the housing part 310 and the process tank 100 is not limited in the embodiments of the present disclosure.

In the embodiments of the present disclosure, the housing part 310 is provided with a first inner cavity 313, which is configured to be respectively connected with the process tank 100 and the water resistance meter 200. A specific way of connecting the first inner cavity 313 with the process tank 100 and the water resistance meter 200 is that, for example, the housing part 310 is further provided with a water inlet 311 and a water outlet 312, and the first inner cavity 313 is respectively connected with the water inlet 311 and the water outlet 312; and the water inlet 311 is configured to be connected with the process tank 100 for receiving the water overflowing from the process tank 100. In a case where the process tank 100 is provided with the overflow hole 101, the water inlet 311 may be connected with the overflow hole 101, so as to receive the water overflowing from the process tank 100. The water outlet 312 is configured to be connected with the water resistance meter 200. When connects with the water inlet 311, the water outlet 312 is used for discharging of the water entering the first inner cavity 313 through the water inlet 311 into the water resistance meter 200, so as to enable the water resistance meter 200 to detect the resistance value of the water. Certainly, in practical applications, the first inner cavity 313 may be connected with the process tank 100 and the water resistance meter 200 in other ways, which is not particularly limited in the embodiments of the present disclosure.

In some embodiments, the water resistance meter 200 may be mounted on the housing part 310 and connected with the water outlet 312. In this case, the housing part 310 may further play the role of providing a mounting position for the water resistance meter 200.

The first inner cavity 313 is respectively connected with the water inlet 311 and the water outlet 312. The first inner cavity 313 may connect the water inlet 311 with the water outlet 312 when the adapter apparatus 300 is in the second state, so as to enable the water entering the first inner cavity 313 through the water inlet 311 to be discharged through the water outlet 312.

The blocking part 320 performs a blocking function. In the embodiments of the present disclosure, the blocking part 320 is movably disposed in the first inner cavity 313, so as to be switched between a first position and a second position. Certainly, it should be noted that the first position refers to one relative position of the blocking part 320 with respect to the housing part 310, and the second position refers to the other relative position of the blocking part 320 with respect to the housing part 310. The blocking part 320 may be movably disposed in the first inner cavity 313 by sliding, rotating, or swinging relative to the housing part 310.

In a case where the blocking part 320 is at the first position, the blocking part 320 blocks the first inner cavity 313, so as to prevent the process tank 100 from being connected with the water resistance meter 200. For example, the blocking part 320 blocks at least one of the water inlet 311 and the water outlet 312, such that the water inlet 311 cannot be connected with the water outlet 312 through the first inner cavity 313. Accordingly, in this case, the chemical solution in the process tank 100 cannot enter the water resistance meter 200 through the water outlet 312, that is, the adapter apparatus 300 is in the first state.

In a case where the blocking part 320 is at the second position, the process tank 100 is connected with the water resistance meter 200 through the first inner cavity 313. For example, the water inlet 311 is connected with the water outlet 312 through the first inner cavity 313, and the water in the process tank 100 may sequentially pass the water inlet 311, the first inner cavity 313, and the water outlet 312, and finally flow into the water resistance meter 200. In this case, the water in the process tank 100 can enter the water resistance meter 200 through the adapter apparatus 300, that is, the adapter apparatus 300 is in the second state.

Certainly, the blocking part 320 may be partially located outside the housing part 310 and partially located inside the housing part 310 (i.e., located inside the first inner cavity 313). The blocking situation of the first inner cavity 313 (e.g., at least one of the water inlet 311 and the water outlet 312) is changed by adjusting the position of the blocking part 320, so as to achieve the purpose of switching the state of the adapter apparatus 300.

In the present embodiment, the housing part 310 can provide a mounting position for the water resistance meter 200, and can be connected to the process tank 100 to realize the connection between the adapter apparatus 300 and the process tank 100, which not only facilitates the mounting of the water resistance meter 200 but also facilitates the mounting of the adapter apparatus 300. Further, as can be seen from the above operation process, only by manipulating the blocking part 320 by the operator to move relative to the housing part 310 in the operation process to switch the blocking part 320 between the first position and the second position, the switching of the adapter apparatus 300 between the first state and the second state can be realized, with no need to rotate the entire adapter apparatus 300. Such method of changing the state of the adapter apparatus 300 by adjusting part of the components of the adapter apparatus 300 can facilitate the adjustment operation and also facilitate the reduction of the operation load.

As described above, the switching of the state of the adapter device 300 can be realized only by the movement of the blocking part 320 relative to the housing part 310. Based on this, the movement of the blocking part 320 may be achieved by manual manipulation, for example, a portion of the blocking part 320 may be exposed outside the housing part 310, and the operator may change the position of the blocking part 320 by manipulating the exposed portion of the blocking part 320, so as to achieve the purpose of adjustment. Certainly, the adapter apparatus 300 may further include a driving member, and the driving member may be a driving motor, a hydraulic telescopic member, or a pneumatic telescopic member for driving the blocking part 320 to move, which is not limited in the embodiments of the present disclosure.

In fact, the blocking part 320 may be at least partially located in the first inner cavity 313, and a misoperation likely caused by the exposure can be avoided with the blocking part 320 disposed in the first inner cavity 313. Certainly, direct operation by the operator is facilitated in a case where the blocking part 320 is partially located outside the housing part 310.

In a case where the blocking part 320 is located in the first inner cavity 313, any manipulation (whether a manual manipulation or a manipulation by the driving member) of the blocking part 320 located in the first inner cavity 313 is faced with the problem of inconvenience because the first inner cavity 313 is a water passing cavity. Based on this, in a further embodiment, the adapter apparatus 300 may further include a rod part 330 and an isolation sleeve 340. The isolation sleeve 340 is fixed in the housing part 310 and sleeved over the rod part 330. The rod part 330 is in a sliding fit with the isolation sleeve 340. The isolation sleeve 340, the housing part 310, and the rod part 330 enclose the first inner cavity 313 on a side of the isolation sleeve 340 close to a first end of the rod part 330, and the blocking part 320 is connected to the first end of the rod part 330, that is, a second end othe rod part 330 passes through the isolation sleeve 340, the first end of the rod part 330 is located in the first inner cavity 313, and the second end of the rod part 330 is located outside the first inner cavity 313. In this case, only by manipulating the second end of the rod part 330 exposed outside the first inner cavity 313, the blocking part 320 can be indirectly driven to change the position thereof in the first inner cavity 313, so as to finally achieve the purpose of conveniently adjusting the state of the adapter apparatus 300.

Certainly, in the semiconductor process device provided in the embodiments of the present disclosure, the blocking part 320 can be driven to move by manually manipulating the second end of the rod part 330 to move or by driving the second end of the rod part 330 to move with the driving member, which is not limited in the present disclosure.

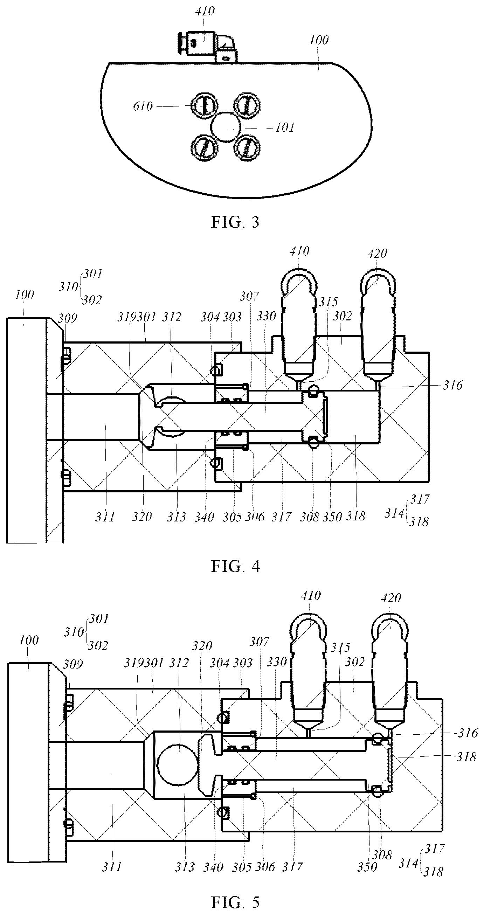

In some embodiments, the isolation sleeve 340, the housing part 310, and the rod part 330 enclose a second inner cavity 314 on a side of the isolation sleeve 340 close to the second end of the rod part 330. Based on this, as listed above, various types of driving members may be adopted, and referring to FIG. 4 to FIG. 6, the embodiments of the present disclosure provide a specific structure of the driving member, which includes a piston 350, and the piston 350 divides the second inner cavity 314 into a first sub-cavity 317 and a second sub-cavity 318, that is, the first sub-cavity 317 is not connected with the second sub-cavity 318.

The housing part 310 is further provided with a first fluid pass-through hole 315 and a second fluid pass-through hole 316. The first fluid pass-through hole 315 and the second fluid pass-through hole 316 are connected with the first sub-cavity 317 and the second sub-cavity 318, respectively. That is, the first fluid pass-through hole 315 is connected with the first sub-cavity 317, and the second fluid pass-through hole 316 is connected with the second sub-cavity 318.

In a case where the first sub-cavity 317 is in a fluid output state and the second fluid pass-through hole 316 is in a fluid input state, a fluid entering the second sub-cavity 318 may drive the piston 350 to drive the blocking part 320 by the rod part 330 to the first position, so as to switch the adapter apparatus 300 to the first state.

In a case where the first sub-cavity 317 is in a fluid input state and the second fluid pass-through hole 316 is in a fluid output state, a fluid entering the first sub-cavity 317 may drive the piston 350 to drive the blocking part 320 by the rod part 330 to the second position.

Such structure can achieve the purpose of driving the piston 350 to move by adjusting the input and the output of the fluid through the first fluid pass-through hole 315 and the second fluid pass-through hole 316, so as to achieve the purpose of driving the blocking part 320 to switch the position thereof by the piston 350 and the rod part 330. In a specific design, the changes of the states of the first fluid passing hole 315 and the second fluid passing hole 316 may be implemented by a fluid inlet pipe and a fluid storage pipe in cooperation with a reversing valve, which has the advantage of simple operation.

Meanwhile, the fluid used by the adapter apparatus 300 having such structure in operation may be a gas or a liquid, which is not limited in the embodiments of the present disclosure. Certainly, the fluid used by the adapter apparatus 300 having such structure in operation may be supplied by a gas source (e.g., a purge gas source of the semiconductor process device) or a liquid source (e.g., a liquid cooling mechanism of the semiconductor process device) of the semiconductor process device, so as to enable the fluid in the semiconductor process device to perform additional functions.

In the embodiments of the present disclosure, the housing part 310 may be an integral structure. For example, the housing part 310 may be an integral structure formed by a bending process. In a specific manufacturing process, the components disposed in the housing part 310 may be placed in advance at predetermined positions of a base material (e.g., a metal plate) used to manufacture the housing part 310, and an internal structure of the housing part 310 is formed by bending the base material, and certainly, arrangement of some components in the housing part 310 may also be realized in the bending process. Certainly, in order to facilitate assembly of the components of the adapter apparatus 300, in some other embodiments, the housing part 310 may include a first sub-housing 301 and a second sub-housing 302, and each of the first sub-housing 301 and the second sub-housing 302 may be provided with a part of the structure of the housing part 310. The first sub-housing 301 and the second sub-housing 302 are hermetically joined to form a sealed accommodating space. For example, the isolation sleeve 340 is mounted in the first sub-housing 301; or the isolation sleeve 340 is mounted in the second sub-housing 302; or a part of the isolation sleeve 340 is mounted in the first sub-housing 301, and the other part of the isolation sleeve 340 is mounted in the second sub-housing 302. The first inner cavity 313 is formed in the first sub-housing 301; and the second inner cavity 314 is formed in the second sub-housing 302. The isolation sleeve 340 divides the accommodating space into the first inner cavity 313 and the second inner cavity 314. Such structure not only facilitates the assembly of the components of the adapter apparatus 300 in the housing part 310, but also facilitates the formation of the first inner cavity 313 and the second inner cavity 314. The isolation sleeve 340 is mounted in the first sub-housing 301 or the second sub-housing 302. In some embodiments, the piston 350 is located in the second inner cavity 314, and the first fluid pass-through hole 315 and the second fluid pass-through hole 316 are formed at the second sub-housing 302. Certainly, the embodiments of the present disclosure are not limited thereto. In practical applications, part of the water inlet 311, the water outlet 312, the first fluid pass-through hole 315, and the second fluid pass-through hole 316 may be formed at the first sub-housing 301, the other part of the water inlet 311, the water outlet 312, the first fluid pass-through hole 315, and the second fluid pass-through hole 316 may be formed at the second sub-housing 302; or all the water inlet 311, the water outlet 312, the first fluid pass-through hole 315, and the second fluid pass-through hole 316 may be formed at the first sub-housing 301; or all the water inlet 311, the water outlet 312, the first fluid pass-through hole 315, and the second fluid pass-through hole 316 may be formed at the second sub-housing 302. Considering that strengths of the first sub-housing 301 and the second sub-housing 302 may be affected due to too many holes formed thereon, in an alternative embodiment, both the water inlet 311 and the water outlet 312 may be formed at the first sub-housing 301, and correspondingly, both the first fluid pass-through hole 315 and the second fluid pass-through hole 316 may be formed at the second sub-housing 302. Such arrangement can not only avoid the problem that the strengths of the first sub-housing 301 and the second sub-housing 302 are reduced due to too many holes formed thereon, but also can arrange the holes having a matching relationship at the first sub-housing 301 or the second sub-housing 302 for easy distinction.

In a further embodiment, in order to facilitate the assembly, the adapter apparatus provided in the present disclosure may further include a first adapter 410 and a second adapter 420. Quick connectors may be adopted as the first adapter 410 and the second adapter 420. Specifically, the first adapter 410 is mounted on the housing part 310, and is connected with the first fluid pass-through hole 315. The second adapter 420 is mounted on the housing part 310, and is connected with the second fluid pass-through hole 316.

In the embodiments of the present disclosure, a tapered hole 319 may be disposed in the housing part 310, and is provided with a smaller port and a larger port. As for the two ports of the tapered hole 319, the smaller port is connected with the water inlet 311, and the larger port is connected with the first inner cavity 313. The blocking part 320 includes a tapered structure matched with the tapered hole 319 in shape, and an outer circumferential surface of the tapered structure is attached to an inner circumferential surface of the tapered hole 319 in a case where the blocking part 320 is at the first position. Since the blocking part 320 is a structure matched with the tapered hole 319 in shape, an inner wall of the tapered hole 319 can perform a guiding function well when the blocking part 320 is moved and switched between the first position and the second position, so that the blocking part 320 can be prevented from skewing, and a good blocking function of the blocking part 320 can be ensured well.

In order to facilitate the assembly, in a further embodiment, one of the first sub-housing 301 and the second sub-housing 302 may be provided with a first positioning groove 303, and the other of the first sub-housing 301 and the second sub-housing 302 may be inserted into the first positioning groove 303 for a plug-in fit with the first positioning groove 303. Certainly, in order to ensure sealing performance, a first seal ring 304 may be disposed between the first sub-housing 301 and the second sub-housing 302. Certainly, the first sub-housing 301 and the second sub-housing 302 may be fixedly connected to each other in a detachable manner by bonding, clamping, or a connector (e.g., a second threaded connector 620). Certainly, the first sub-housing 301 and the second sub-housing 302 may be connected to each other with a non-detachable fixing method. In consideration of replacement and maintenance of the components in the housing part 310, the first sub-housing 301 and the second sub-housing 302 may be fixedly connected to each other with a detachable connection method. A specific connection method for the first sub-housing 301 and the second sub-housing 302 is not limited in the embodiments of the present disclosure.

In order to alleviate displacement of the isolation sleeve 340 in the housing part 310, in a further embodiment, a second positioning groove 305 may be provided inside the housing part 310, and the isolation sleeve 340 may be positioned in the second positioning groove 305. Specifically, the second positioning groove 305 may be formed in the first sub-housing 301 or the second sub-housing 302.

Certainly, a second seal ring 306 may be disposed in the second positioning groove 305, and may be sandwiched firmly between a sidewall of the second positioning groove 305 and the isolation sleeve 340, thereby ensuring sealed isolation of the first inner cavity 313 from the second inner cavity 314. Certainly, the isolation sleeve 340 is sleeved outside the rod part 330, and a third seal ring 307 may be disposed between the isolation sleeve 340 and the rod part 330, so as to better ensure the sealing isolation of the first inner cavity 313 from the second inner cavity 314.

Similarly, in order to better achieve the isolation of the first sub-cavity 317 from the second sub-cavity 318, in an alternative embodiment, a fourth seal ring 308 may be disposed between the piston 350 and an inner wall of the housing part 310. The fourth seal ring 308 can hermetically isolate the first sub-cavity 317 from the second sub-cavity 318 well, which helps the fluid to drive the piston 350 to move.

As described above, the housing part 310 may be mounted outside the process tank 100, and the water inlet 311 is joined to the overflow hole 101. Similarly, in order to avoid leakage at a joined position, in an alternative embodiment, a fifth seal ring 309 may be disposed between the housing part 310 and the process tank 100. Specifically, a mounting groove may be formed at the housing part 310, and the fifth seal ring 309 may be mounted in the mounting groove.

The semiconductor process device provided in the embodiments of the present disclosure may be a tank-type cleaning machine, or may be other types of semiconductor process devices which are provided with the processing tank 100 and not limited to a cleaning function, and a specific type of the semiconductor process device is not limited in the embodiments of the present disclosure.

Referring to FIG. 1, in a further embodiment, the semiconductor process device provided in the present disclosure may further include a plurality of branches 510, a plurality of switching valves 520, and a common pipe 530.

The plurality of branches 510 may be respectively connected with different chemical solution sources, and connected in parallel at a first end of the common pipe 530, and a second end of the common pipe 530 is connected with the process tank 100. The plurality of switching valves 520 are disposed on the plurality of branches 510 in a one-to-one correspondence manner, and are configured to control on and off of the corresponding branches 510.

In specific operation processes, since the process tank 100 is a multifunctional tank, the operator may selectively turn on corresponding branches 510 based on different processes, so as to introduce process liquids into the process tank 100 for the corresponding processes. In such structure, the plurality of branches 510 can share the common pipe 530, which achieves the purpose of simplifying the structure of the semiconductor process device.

In the embodiments of the present disclosure, the process tank 100 has a plurality of functions, and is not limited to a water cleaning function. In a case where the process tank 100 contains other chemical solutions which may be corrosive, in order to avoid an influence of the corrosive chemical solutions on service life of the adapter apparatus 300, the components of the adapter apparatus 300 provided in the embodiments of the present disclosure may be made of corrosion-resistant materials. For the components which possibly have relatively large contact area with the chemical solutions, in some embodiments, a material of the housing part 310 includes polyvinylidene difluoride (PVDF), for example, a PVDF housing is adopted as the housing part 310. A material of the blocking part 320 includes a poly tetra fluoroethylene (PTFE), for example, the housing part 310 may be a PTFE structural member.

The above embodiments of the present disclosure focus on the differences between the embodiments, and different optimization features of the embodiments can be combined to form better embodiments as long as the different optimization features are not contradictory, which will not be described in detail here for conciseness of the description.

The embodiments of the present disclosure are described above with reference to the drawings, but the present disclosure is not limited to the above specific implementations which are just for illustration rather than for limitation. Enlightened by the present disclosure, those of ordinary skill in the art can make many variations without departing from the spirit of the present disclosure and the scope of the claims, and all those variations should be considered to fall within the scope of the present disclosure.

## Claims

1. An adapter apparatus, wherein the adapter apparatus is configured to connect a water resistance meter to a process tank, and comprises a housing part and a blocking part;
the housing part is provided with a first inner cavity, and the first inner cavity is configured to be respectively connected with the process tank and the water resistance meter; and
the blocking part is movably disposed in the first inner cavity to be switched between a first position and a second position; in a case where the blocking part is at the first position, the blocking part blocks the first inner cavity; and in a case where the blocking part is at the second position, the process tank is connected with the water resistance meter through the first inner cavity.

2. The adapter apparatus of claim 1, wherein the housing is further provided with a water inlet and a water outlet, and the first inner cavity is respectively connected with the water inlet and the water outlet; and
the water inlet is configured to be connected with the process tank; the water outlet is configured to be connected with the water resistance meter; and in a case where the blocking part is at the first position, the blocking part blocks at least one of the water inlet and the water outlet.

3. The adapter apparatus of claim 1 or 2, further comprising a rod part and an isolation sleeve, wherein
the isolation sleeve is fixed in the housing part, and is sleeved over the rod part, the rod part is in a sliding fit with the isolation sleeve, the isolation sleeve, the housing part, and the rod part enclose the first inner cavity on a side of the isolation sleeve close to a first end of the rod part, and the blocking part is connected to the first end of the rod part.

4. The adapter apparatus of claim 3, further comprising a driving member, wherein the driving member is connected to the rod part for driving the rod part to move the blocking part between the first position and the second position.

5. The adapter apparatus of claim 4, wherein the isolation sleeve, the housing part, and the rod part enclose a second inner cavity on a side of the isolation sleeve close to a second end of the rod part, the driving member comprises a piston, and the piston divides the second inner cavity into a first sub-cavity and a second sub-cavity;
the housing part is further provided with a first fluid pass-through hole and a second fluid pass-through hole which are connected with the first sub-cavity and the second sub-cavity, respectively; and in a case where the first fluid pass-through hole is in a fluid output state and the second fluid pass-through hole is in a fluid input state, a fluid entering the second sub-cavity drives the piston to drive the blocking part by the rod part to the first position; and
in a case where the first fluid pass-through hole is in a fluid input state and the second fluid pass-through hole is in a fluid output state, a fluid entering the first sub-cavity drives the piston to drive the blocking part by the rod part to the second position.

6. The adapter apparatus of claim 5, wherein the housing part comprises a first sub-housing and a second sub-housing, the first sub-housing and the second sub-housing are hermetically joined to form an accommodating space, the isolation sleeve divides the accommodating space into the first inner cavity and the second inner cavity, and the first inner cavity is formed in the first sub-housing and the second inner cavity is formed in the second sub-housing.

7. The adapter apparatus of claim 6, wherein the piston is located in the second inner cavity, and the first fluid pass-through hole and the second fluid pass-through hole are formed at the second sub-housing.

8. The adapter apparatus of claim 6, wherein one of the first sub-housing and the second sub-housing is provided with a first positioning groove, the other of the first sub-housing and the second sub-housing is inserted into the first positioning groove for a plug-in fit with the first positioning groove, the first sub-housing is detachably and fixedly connected to the second sub-housing, and a first seal ring is disposed between the first sub-housing and the second sub-housing.

9. The adapter apparatus of claim 5, further comprising a first adapter and a second adapter, wherein the first adapter is mounted on the housing part, and is connected with the first fluid pass-through hole, and the second adapter is mounted on the housing part, and is connected with the second fluid pass-through hole.

10. The adapter apparatus of claim 2, wherein the housing part is provided with a tapered hole, a smaller port of two ports of the tapered hole is connected with the water inlet, a larger port of the two ports of the tapered hole is connected with the first inner cavity, the blocking part comprises a tapered structure matched with the tapered hole in shape, and an outer circumferential surface of the tapered structure is attached to an inner circumferential surface of the tapered hole in a case where the blocking part is at the first position.

11. The adapter apparatus of claim 1, wherein a material of the housing part comprises polyvinylidene difluoride, and/or a material of the blocking part comprises poly tetra fluoroethylene.

12. A semiconductor process device, comprising a process tank, a water resistance meter, and the adapter apparatus of any one of claims 1 to 11, wherein
the process tank is provided with an overflow hole;
the adapter apparatus is disposed outside the process tank, and the first inner cavity is connected with the overflow hole; and
the water resistance meter is mounted on the housing part, and is connected with the first inner cavity.

13. A semiconductor process device, comprising a process tank, a water resistance meter, and an adapter apparatus, wherein
the process tank is provided with an overflow hole, and the adapter apparatus is mounted outside the process tank, and is connected with the process tank through the overflow hole;
the water resistance meter is mounted on the adapter apparatus, and the adapter apparatus has a first state and a second state;
in a case where the semiconductor process device is in a cleaning state, the adapter apparatus is in the second state, and connects the water resistance meter with the process tank; and
in a case where the semiconductor process device is in a non-cleaning state, the adapter apparatus is in the first state, and isolates the water resistance meter from the process tank.

14. The semiconductor process device of claim 12 or 13, comprising a plurality of branches, a plurality of switching valves, and a common pipe; wherein
the plurality of branches are connected in parallel at a first end of the common pipe, and a second end of the common pipe is connected with the process tank; and
the plurality of switching valves are disposed on the plurality of branches in a one-to-one correspondence manner, and are configured to control on and off of the corresponding branches.
